# EUROPEAN PATENT APPLICATION

(11) **EP 2 532 508 A1**
(43) Date of publication of application: **12.12.2012**
(21) Application number: 11739716.6
(22) Date of filing: 31.01.2011
(51) Int. Cl.: B29C 59/02, B29C 33/38, H01L 21/027

(54) **PROCESS FOR PRODUCING ARTICLE HAVING FINELY RUGGED STRUCTURE ON SURFACE**

(30) Priority: 03.02.2010 JP 2010022235
(71) Applicant: Asahi Glass Company, Limited, Tokyo 100-8405 (JP)
(72) Inventor: KOIKE Akio, Tokyo 100-8405 (JP); KIKUGAWA Shinya, Tokyo 100-8405 (JP); NISHIHARA Yoshiyuki, Tokyo 100-8405 (JP)
(74) Representative: Müller-Boré & Partner Patentanwälte
(86) International application number: PCT/JP2011/051946
(87) International publication number: WO 2011/096368

(57) **Abstract**

The present invention relates to a method for producing an article having a fine concave and convex structure on a surface thereof, comprising the following steps (i) to (iii): (i) step of sandwiching a photocurable composition between a mold having an inverted structure of the fine concave and convex structure on a surface thereof and a substrate such that the photocurable composition is in contact with the surface having the inverted structure of the mold; (ii) step of irradiating the photocurable composition with light while keeping the photocurable composition sandwiched between the mold and the substrate to cure the photocurable composition to form a cured product; and (iii) step of separating the mold from the cured product to obtain an article comprising the substrate having on a surface thereof the cured product having the fine concave and convex structure on a surface thereof, in which the mold contains TiO₂-containing quartz glass, and at least the step (i) is conducted in a helium gas atmosphere.

## Description

### TECHNICAL FIELD

The present invention relates to a method for producing a photocurable composition, a photocurable composition obtained by the production method, and an article obtained using the photocurable composition.

### BACKGROUND ART

As a method for forming a fine concave and convex structure in a short period of time in the production of a semiconductor device, an optical member, a recording medium and the like, there is a known method (photo-imprint method) of forming a fine concave and convex structure on a surface of a substrate by: pressing a mold having an inverted structure with the fine concave and convex structure on a surface thereof, to a liquid photocurable composition provided on the surface of the substrate; and irradiating the photocurable composition with light, thereby curing the photocurable composition (see Patent Documents 1 and 2).
As the mold used in the photo-imprint method, a mold formed of quartz glass that transmits light is generally used since, in a production of a semiconductor device, a silicone wafer serving as a substrate does not transmit light.

By the way, there may be a case where, in pressing a mold to a liquid photocurable composition, the photocurable composition is not filled in every corner of concave portions in an inverted structure of the mold, and bubbles remain in the concave portions. Where the photocurable composition is cured while retaining bubbles in the concave portions of the mold, deficit (defect) originated from bubbles generates in convex portion of the fine concave and convex structure formed.

### RELATED ART DOCUMENTS

### PATENT DOCUMENTS

Patent Document 1: US Patent 6,696,220
Patent Document 2: JP-A 2004-071934

### SUMMARY OF THE INVENTION

### PROBLEMS TO BE SOLVED BY THE INVENTION

The present invention provides a method that can produce an article having a fine concave and convex structure on a surface thereof in good productivity while suppressing defect generated in the fine concave and convex structure.

### MEANS FOR SOLVING THE PROBLEMS

The method for producing an article having a fine concave and convex structure on a surface thereof according to the present invention, comprises the following steps (i) to (iii):
(i) step of sandwiching a photocurable composition between a mold having an inverted structure of the fine concave and convex structure on a surface thereof and a substrate such that the photocurable composition is in contact with the surface having the inverted structure of the mold;
(ii) step of irradiating the photocurable composition with light while keeping the photocurable composition sandwiched between the mold and the substrate to cure the photocurable composition to form a cured product; and
(iii) step of separating the mold from the cured product to obtain an article containing the substrate having on a surface thereof the cured product having the fine concave and convex structure on a surface thereof,
in which the mold contains TiO₂-containing quartz glass, and at least the step (i) is conducted in a helium gas atmosphere.

In the method for producing an article having a fine concave and convex structure on a surface thereof according to the present invention, the mold preferably has an arithmetic average roughness Ra of a bottom face of a concave portion in the inverted structure of the fine concave and convex structure of from 1 to 30 nm.
In the method for producing an article having a fine concave and convex structure on a surface thereof according to the present invention, the mold preferably contains the TiO₂-containing quartz glass having a TiO₂ concentration of from 2 to 10% by mass.
In the method for producing an article having a fine concave and convex structure on a surface thereof according to the present invention, the helium gas atmosphere is preferably an atmosphere having a concentration of helium gas of from 50% by volume or more.

### EFFECT OF THE INVENTION

According to the production method of the present invention, an article having a fine concave and convex structure on a surface thereof can be produced in good productivity while suppressing defect generated in the fine concave and convex structure.

### BRIEF DESCRIPTION OF THE DRAWINGS

[Fig. 1] Fig. 1 is a cross-sectional view showing one step in method (α) of sandwiching a photocurable composition between a mold and a substrate.
[Fig. 2] Fig. 2 is a cross-sectional view showing one step in method (α) of sandwiching a photocurable composition between a mold and a substrate.
[Fig. 3] Fig. 3 is a cross-sectional view showing one step in method (β) of sandwiching a photocurable composition between a mold and a substrate.
[Fig. 4] Fig. 4 is a cross-sectional view showing one step in method (β) of sandwiching a photocurable composition between a mold and a substrate.
[Fig. 5] Fig. 5 is a cross-sectional view showing one step in method (γ) of sandwiching a photocurable composition between a mold and a substrate.
[Fig. 6] Fig. 6 is a cross-sectional view showing one step in method (γ) of sandwiching a photocurable composition between a mold and a substrate.
[Fig. 7] Fig. 7 is a cross-sectional view showing one example of an article having a fine concave and convex structure on a surface thereof.

### MODE FOR CARRYING OUT THE INVENTION

The method for producing an article having a fine concave and convex structure on a surface thereof according to the present invention is a method containing the following steps (i) to (iii).
(i) Step of sandwiching a photocurable composition between a mold having an inverted structure of the fine concave and convex structure on a surface thereof and a substrate such that the photocurable composition is in contact with the surface having the inverted structure of the mold.
(ii) Step of irradiating the photocurable composition with light while keeping the photocurable composition sandwiched between the mold and the substrate to cure the photocurable composition to form a cured product.
(iii) Step of separating the mold from the cured product to obtain an article containing the substrate having on a surface thereof the cured product having the fine concave and convex structure on a surface thereof.

In the method for producing an article having a fine concave and convex structure on a surface thereof according to the present invention, as the mold, one containing TiO₂-containing quartz glass is used, and at least the step (i) is conducted in a helium gas atmosphere.
The TiO₂-containing quartz glass (TiO₂-SiO₂ glass) has excellent gas permeability, particularly helium gas permeability, as compared with TiO₂-free quartz glass (SiO₂ glass). For this reason, even though bubbles of helium gas remain in concave portions in an inverted structure of the mold, the bubbles are absorbed in the mold in a relatively short period of time as compared with the case in air atmosphere or the case of using a mold formed of TiO₂-free quartz glass.

The helium gas atmosphere means an atmosphere containing helium gas as a main component, and a concentration of the helium gas is preferably 50% by volume or more, more preferably 75% by volume or more, and further preferably 90% by volume or more.
In the production method of the present invention, the steps (i) to (iii) may be conducted in a helium gas atmosphere. However, from the standpoint of suppressing an amount of helium gas used as possible, it is preferred that only the step (i) is conducted in a helium gas atmosphere. When at least the step (i) is conducted in a helium gas atmosphere, the effect of the present invention is sufficiently exerted.

### <Step (i)>

### (Mold)

The mold has an inverted structure of a fine concave and convex structure on a surface thereof.
The inverted structure of a fine concave and convex structure is a structure that a fine concave and convex structure on a surface of an intended article is inverted, and includes a plurality of fine convex portions and/or concave portions.
Examples of the convex portion include long protrusions extending on a surface of a mold, and projections scattered on the surface.
Examples of the concave portion include long grooves extending on a surface of a mold and holes scattered on the surface.

Examples of a shape of the protrusion or the groove include a straight line, a curved line and a broken line shape. The protrusion or the groove may be that a plurality thereof is present in parallel to form a stripe shape.
Examples of a cross-sectional shape in a direction perpendicular to the longitudinal direction of the protrusion or groove include a rectangle, a trapezoid, a triangle and a semicircle.
Examples of a shape of the projection or the hole include a triangular prism, a quadrangular prism, a hexagonal prism, a column, a triangular pyramid, a quadrangular pyramid, a six-sided pyramid, a circular cone, a hemisphere and a polyhedron.

Width of the protrusion or the groove is preferably from 1nm to 500 µm, more preferably from 10 nm to 100 µm, and further preferably from 15 nm to 10 µm, on average. The width of the protrusion means a length of a base in a cross-section in a direction perpendicular to the longitudinal direction. The width of the groove means a length of an upper side in a cross-section in a direction perpendicular to the longitudinal direction.
Width of the projection or the hole is preferably from 1 nm to 500 µm, more preferably from 10 nm to 100 µm, and further preferably from 15 nm to 10 µm, on average. The width of the projection means a length of a base in a cross-section in a direction perpendicular to the longitudinal direction in the case that the base has a long and slender shape, or means a maximum length in a base of the projection in other cases. Width of the hole means a length of an upper side in a cross-section in a direction perpendicular to the longitudinal direction in the case that the opening has a long and slender shape, or means a maximum length in an opening of the hole in other cases.

Height of the convex portion is preferably from 1 nm to 500 µm, more preferably from 10 nm to 100 µm, and further preferably from 15 nm to 10 µm, on average.
Depth of the concave portion is preferably from 1 nm to 500 µm, more preferably from 10 nm to 100 µm, and further preferably from 15 nm to 10 µm, on average.

In a region at which a fine concave and convex structure is dense, an interval between the adjacent convex portions (or concave portions) is preferably from 1 nm to 500 µm, and more preferably from 1 nm to 50 µm, on average. The interval between the adjacent convex portions means a distance of from an end edge of a base in a cross section of the convex portion to a start edge of a base in a cross section of the adjacent convex portion. The interval between the adjacent concave portions means a distance of from an end edge of an upper side in a cross section of the concave portion to a start edge of an upper side in a cross section of the adjacent concave portion.

Minimum dimension of the convex portion is preferably from 1 nm to 50 µm, more preferably from 1 nm to 500 nm, and particularly preferably from 1 nm to 50 nm. The minimum dimension means minimum dimension in width, length and height of the convex portion.
Minimum dimension of the concave portion is preferably from 1 nm to 50 µm, more preferably from 1 nm to 500 nm, and particularly preferably from 1 nm to 50 nm. The minimum dimension means minimum dimension in width, length and height of the concave portion.

Arithmetic average roughness Ra of a bottom face of the concave portion is preferably from 1 to 30 nm. When the arithmetic average roughness Ra of a bottom face of the convex portion is 1 nm or more, an area contacting helium gas is increased, and helium gas permeability (absorbability) in the bottom face becomes more excellent. The arithmetic average roughness Ra is more preferably 2 nm or more, and further preferably 5 nm or more. Where the arithmetic average roughness Ra of a bottom face of the concave portion exceeds 30 nm, roughness itself of the bottom face may become a defect in the convex portion of a fine concave and convex structure of the intended article. The arithmetic average roughness Ra is more preferably 20 nm or less, and further preferably 15 nm or less.
The Ra is preferably 1/2 or less of a height of the convex portion or a depth of the concave portion.
The arithmetic average roughness Ra is an arithmetic average roughness Ra defined in JIS B0601 (2001), and is measured using an atomic force microscope.

As a mold, one containing TiO₂-containing quartz glass (hereinafter referred to as "TiO₂-SiO₂ glass") is used from the standpoint of excellent permeability (absorbability) of helium gas. TiO₂-free quartz glass does not have sufficient permeability (absorbability) of helium gas, and takes much time until bubbles disappear. Therefore, in the case where a mold containing TiO₂-free quartz glass is used, productivity of an article having a fine concave and convex structure on a surface thereof is decreased.

The TiO₂-SiO₂ glass is a quartz glass containing TiO₂ as a dopant.
TiO₂ concentration in the TiO₂-SiO₂ glass (100% by mass) is preferably from 2 to 10% by mass. When the TiO₂ concentration is from 2 to 10% by mass, permeability (absorbability) of helium gas is sufficiently increased. The TiO₂ concentration is more preferably from 3 to 8% by mass, and further preferably from 4 to 6.5% by mass.
The TiO₂ concentration is measured using a fundamental parameter (FP) method in a fluorescent X-ray spectroscopy.

The mold containing the TiO₂-SiO₂ glass can be prepared by a method of preparing a TiO₂-SiO₂ glass substrate, and forming an inverted structure on a surface of the TiO₂-SiO₂ glass substrate.

A method for preparing the TiO₂-SiO₂ glass substrate includes the conventional method such as the method containing the following steps (a) to (f).
(a) Step of depositing TiO₂-SiO₂ glass fine particles obtained from a glass-forming raw material(s) containing an SiO₂ precursor and a TiO₂ precursor by a soot method, to obtain a porous TiO₂-SiO₂ glass body.
(b) Step of heating the porous TiO₂-SiO₂ glass body to a densification temperature, to obtain a TiO₂-SiO₂ dense body.
(c) Step of heating the TiO₂-SiO₂ dense body to a transparent vitrification temperature, to obtain a transparent TiO₂-SiO₂ glass body.
(d) If needed, step of heating the transparent TiO₂-SiO₂ glass body to a softening temperature and molding it, to obtain a molded TiO₂-SiO₂ glass body.
(e) If needed, step of subjecting the transparent TiO₂-SiO₂ glass body obtained by the step (c) or the molded TiO₂-SiO₂ glass body obtained in the step (d) to an annealing treatment.
(f) Step of subjecting the TiO₂-SiO₂ glass body obtained in any one of the steps (c) to (e) to mechanical processing such as cutting, shaving, grinding or polishing, to obtain an TiO₂-SiO₂ glass substrate having a given shape.
In the above steps, it is preferred that the helium concentration in a heat treatment atmosphere is set to 1% or less in the steps after the step (b) in which a dense body is formed or the step (c) in which a dense body has been formed. By this, the helium concentration in the TiO₂-SiO₂ glass substrate obtained is decreased. With decreasing the helium concentration in the TiO₂-SiO₂ glass substrate, permeability (absorbability) of helium gas becomes good. The step (b) is more preferably conducted under reduced pressure, and further preferably conducted under reduced pressure in an atmosphere containing nitrogen gas or argon gas as a main component. The steps after the step (c) in which a dense body has been formed is more preferably conducted in an atmosphere containing nitrogen gas or argon gas as a main component, and further preferably conducted in an atmosphere containing argon gas as a main component.

The method for forming an inverted structure of a fine concave and convex structure on a surface of the TiO₂-SiO₂ glass substrate includes a method by etching. The etching is preferably dry etching. Specifically, a reactive ion etching by SF₆ is preferred.

### (Substrate)

Examples of the substrate of an article include inorganic material substrates and organic material substrates.
Examples of the inorganic material include a silicon wafer, glass, quartz glass, a metal (aluminum, nickel, copper and the like), a metal oxide (alumina and the like), silicon nitride, aluminum nitride, and lithium niobate.
Examples of the organic material include a fluorine resin, a silicone resin, an acrylic resin, polycarbonate, polyester (polyethylene terephthalate and the like), polyamide, polypropylene, polyethylene, a nylon resin, polyphenylene sulfide, and cyclic polyolefin.

As the substrate, use can be made of a surface-treated substrate from the standpoint of excellent adhesiveness to a photocurable composition. Examples of the surface treatment include a primer coating treatment, an ozone treatment and a plasma etching treatment. Examples of the primer include a silane coupling agent and silazane.

### (Photocurable composition)

As the photocurable composition, use can be made of known light imprint materials such as a radical polymerization resin composition, a cationic polymerization resin composition, an enthiol resin composition, a fluorine-containing material, and an organic-inorganic hybrid material; and photocurable compositions known in literatures, such as photocurable compositions described in paragraphs [0029] to [0074] in the specification of WO2007/116972 pamphlet. The radical polymerization resin composition capable of being photocured by photoradical polymerization is preferred from the standpoint of productivity.

### (Sandwiching method)

The method for sandwiching the photocurable composition between the mold and the substrate includes the following methods (α) to (γ).

### Method (α):

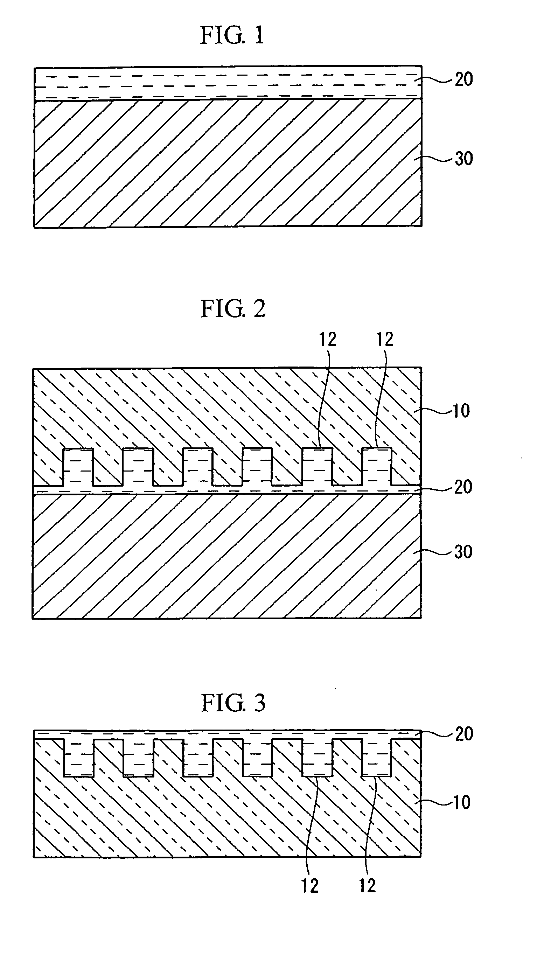

Method containing the following steps (α-1) and (α-2).
(α-1) Step of arranging a photocurable composition 20 on a surface of a substrate 30 as shown in Fig. 1.
(α-2) Step of pressing a mold 10 to the photocurable composition 20 such that an inverted structure containing a plurality of concave portions 12 of the mold 10 comes into contact with the photocurable composition 20 as shown in Fig. 2.

### Method (β):

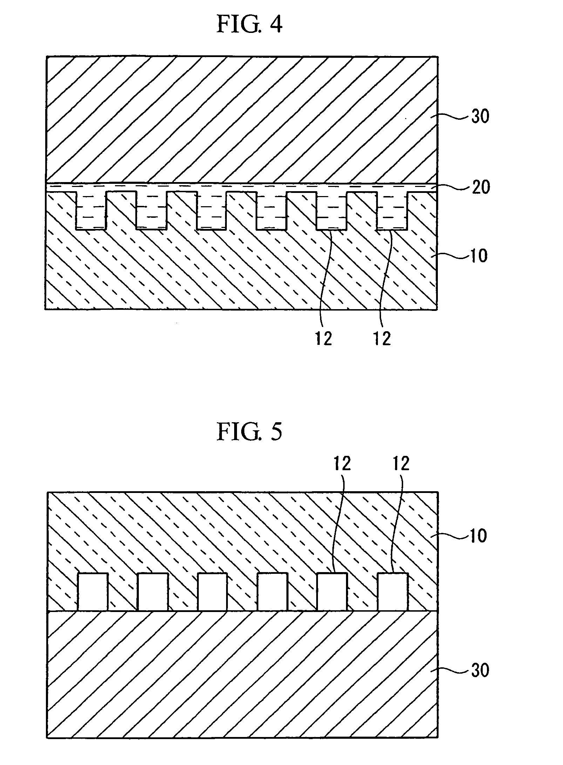

Method containing the following steps (β-1) and (β-2).
(β-1) Step of arranging the photocurable composition 20 on a surface having the inverted structure containing a plurality of the concave portions 12 of the mold 10 as shown in Fig. 3.
(β-2) Step of pressing the substrate 30 to the photocurable composition 20 on the surface of the mold 10 in Fig. 4.

### Method (γ):

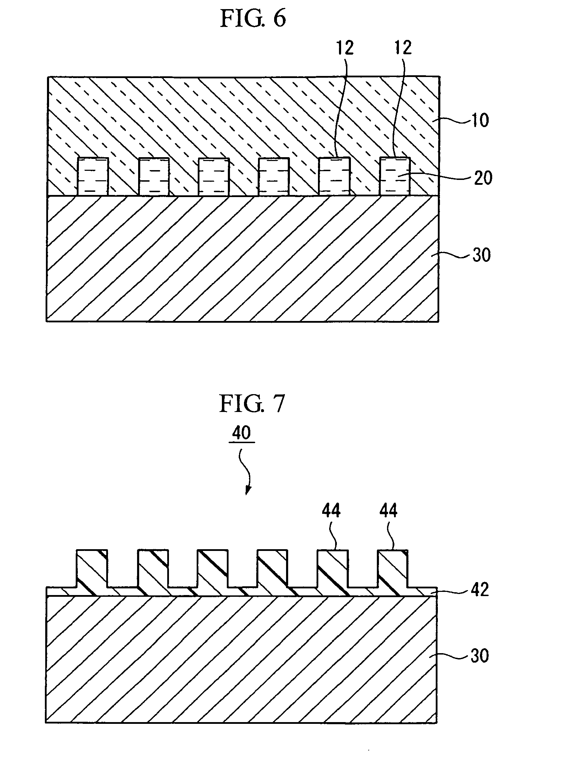

Method containing the following steps (γ-1) and (γ-2).
(γ-1) Step of contacting or approaching the substrate 30 and the mold 10 such that the inverted structure containing a plurality of the concave portions 12 of the mold 10 faces the substrate 30 side as shown in Fig. 5.
(γ-2) Step of filling the photocurable composition 20 to a gap between the substrate 30 and the mold 10 as shown in Fig. 6.

### Step (α-1):

Examples of the arrangement method of the photocurable composition include an inkjet method, a potting method, a spin coating method, a roll coating method, a casting method, a dip coating method, a die coating method, Langmuir Blodgett method and a vacuum deposition method.
The photocurable composition may be arranged on the entire surface of the substrate, and may be arranged on a part of the surface of the substrate.

### Step (α-2):

Pressing pressure (gauge pressure) when pressing the mold to the photocurable composition is preferably from more than 0 to 10 MPa, and more preferably from 0.1 MPa to 5 MPa. Temperature when pressing the mold to the photocurable composition is preferably from 0 to 100°C, and more preferably from 10 to 60°C.

### Step (β-1):

Examples of the arrangement method of the photocurable composition include an inkjet method, a potting method, a spin coating method, a roll coating method, a casting method, a dip coating method, a die coating method, Langmuir Blodgett method and a vacuum deposition method.
The photocurable composition may be arranged on the entire surface of the inverted structure of the mold, and may be arranged on a part of the inverted structure. The photocurable composition is preferably arranged on the entire surface of the inverted structure.

### Step (β-2):

Pressing pressure (gauge pressure) when pressing the substrate to the photocurable composition is preferably from more than 0 to 10 MPa, and more preferably from 0.1 MPa to 5 MPa. Temperature when pressing the substrate to the photocurable composition is preferably from 0 to 100°C, and more preferably from 10 to 60°C.

### Step (γ-2):

The method of filling the photocurable composition to a gap between the substrate and the mold includes a method of sucking the photocurable composition in voids by capillary action.
Temperature when filling the photocurable composition is preferably from 0 to 100°C, and more preferably from 10 to 60°C.

### <Step (ii)>

The state of sandwiching the photocurable composition between the mold and the substrate is maintained for a certain period of time. Period of time of from completion of the sandwiching of the photocurable composition to initiation of light irradiation to the photocurable composition is at least a sufficient period of time required for bubbles of helium gas remained in the concave portions of the mold to disappear and at most a period of time not to impair productivity. A range of the optimal period of time is appropriately determined depending on a material of the mold, a temperature of an atmosphere, and the like. The period of time of from completion of the sandwiching of the photocurable composition to initiation of light irradiation to the photocurable composition is preferably from about 5 seconds to 3 minutes, more preferably from about 10 to 30 seconds, and further preferably from about 10 to 20 seconds.

The light irradiation is generally conducted from the mold side. However, in the case that the substrate has light transparency, the light irradiation may be conducted from the substrate side. Wavelength of light is preferably from 200 to 500 nm. In conducting the light irradiation, the photocurable composition may be heated to accelerate curing.
Temperature when conducting light irradiation is preferably from 0 to 100°C, and more preferably from 10 to 60°C.

### <Step (iii)>

By separating the mold from a cured product, the inverted structure containing a plurality of concave portions 12 of the mold 10 is printed to obtain an article 40 containing the substrate 30 having on a surface thereof a cured product 42 having formed on a surface thereof a fine concave and convex structure containing a plurality of convex portions 44, as shown in Fig. 7.
Temperature when separating the mold from the cured product is preferably from 0 to 100°C, and more preferably from 10 to 60°C.

Examples of the article having a fine concave and convex structure on a surface thereof include the following articles.
Intermediates containing a silicon wafer having formed thereon a resist film with a given pattern, obtained in the course of a production process of a semiconductor device.
Optical elements: microarray lens, optical waveguide element, optical switching element (grid polarized element, wave plate or the like), Fresnel zone plate element, binary element, blaze element, photonic crystal, and the like.
Antireflection members: AR (Anti Reflection) coated member, and the like.
Chips: biochip, chip for µ-TAS (Micro-Total Analysis Systems), microreactor chip, and the like.
Others: recording media, display material, support of catalyst, filter, sensor member, daughter mold for nanoimprint, and the like.

In the case where the article 40 of the present invention is an intermediate containing a silicon wafer (substrate 30) having formed thereon a resist film (cured product 42) with a given pattern, which can be obtained in the course of a production process of a semiconductor device, a thin resist residual film present on the bottom face of the concave portion between the convex portions 44 needs to be removed to expose a surface of silicon. A method for removing the resist residual film includes a method by oxygen-reactive ion etching or the like. After removing the resist residual film, etching may be conducted using a resist film as a mask, or aluminum or the like is deposited and lifted-off, followed by utilizing as a wiring.

According to the method for producing an article having a fine concave and convex structure on a surface thereof according to the present invention as described above, in the method containing the above-described steps (i) to (iii), a mold containing a TiO₂-containing quartz glass is used as a mold, and at least the step (i) is conducted in a helium gas atmosphere. Therefore, even though bubbles of the helium gas remain in the concave portions in the inverted structure of the mold, the bubbles are absorbed in the mold containing the TiO₂-containing quartz glass having excellent gas permeability in a relatively short period of time. As a result, an article having a fine concave and convex structure on the surface thereof can be produced with good productivity while suppressing deficit (defect) originated from the bubbles, generated in the fine concave and convex structure.

### EXAMPLES

The present invention will be described below by reference to Examples, but the invention is not limited to those Examples.
Example 1 is Invention Example, and Example 2 is Comparative Example.

### (TiO₂ concentration)

TiO₂ concentration in a TiO₂-containing quartz glass is measured using a fundamental parameter (FP) method in fluorescent X-ray spectroscopy.

### (Imprint simulation test)

Two quartz glass-system substrates are placed in a chamber having a helium gas (100% by volume) atmosphere. A photocurable composition is arranged on a surface of one quartz glass-system substrate. Other quartz glass-system substrate is pressed to the photocurable composition. Bubbles having a size of about 50 µm present between the photocurable composition and the quartz glass-system substrates sandwiching the photocurable composition are observed, and the period of time of from completion of the sandwiching of the photocurable composition to disappearance of bubbles is measured.

### (Arithmetic average roughness Ra)

Arithmetic average roughness Ra defined in JIS B0601 (2001) is measured on a bottom face of a concave portion in an inverted structure of a mold using an atomic force microscope.

### (Continuous print test)

A mold and a silicon wafer are placed in a chamber having a helium gas (100% by volume) atmosphere. A photocurable composition is arranged on a surface of the silicon wafer. The mold is pressed to the photocurable composition such that an inverted structure of the mold is in contact with the photocurable composition. The photocurable composition is irradiated with ultraviolet rays from a high pressure mercury lamp for 15 seconds to cure the photocurable composition. The mold is separated from the cured product, thereby obtaining an article containing the silicon wafer having on a surface thereof the cured product having formed on a surface thereof a fine concave and convex structure containing a plurality of convex portions. Those procedures are repeated several times.

### (Photocurable composition)

Into a 1,000 mL four-necked flask equipped with a stirrer and a condenser tube are charged:
60 g of dipentaerythritol hexaacrylate (manufactured by Shin-Nakamura Chemical Co., Ltd., NK Ester A-DPH);
40 g of neopentyl glycol diacrylate (manufactured by Shin-Nakamura Chemical Co., Ltd., NK Ester A-NPG),
4.0 g of a photopolymerization initiator (manufactured by Ciba Specialty Chemicals, IRGACURE 907),
0.1 g of a fluorine-containing surfactant (manufactured by Asahi Glass Co., Ltd., an oligomer of fluoroacrylate (CH₂=CHCOO(CH₂)₂(CF₂)₈F) and butyl acrylate, fluorine content: about 30% by mass, mass average molecular weight: about 3,000),
1.0 g of a polymerization inhibitor (manufactured by Wako Pure Chemical Industries, Ltd., Q1301), and
65.0 g of cyclohexane.

The resulting mixture is stirred for 1 hour in a state that the inside of the flask is kept at ordinary temperature and shielded from light, to thereby homogenize the mixture. To the flask is gradually added 100 g (solid content: 30 g) of colloidal silica while stirring the inside of the flask, followed by stirring for 1 hour in a state that the inside of the flask is kept at ordinary temperature and shielded from light, to thereby homogenize the mixture. Subsequently, to the flask is added 340 g of cyclohexane, followed by stirring for 1 hour in a state that the inside of the flask is kept at ordinary temperature and shielded from light, to thereby obtain a photocurable composition.

### [Example 1]

### (Step (a))

TiCl₄ and SiCl₄ as glass forming raw materials are gasified, respectively, and then mixed. The resulting mixed gas is subjected to heat hydrolysis (flame hydrolysis) in oxyhydrogen flame to obtain TiO₂-SiO₂ glass fine particles, and the particles are deposited on a substrate for deposition and are grown thereon, to thereby form a porous TiO₂-SiO₂ glass body.
The porous TiO₂-SiO₂ glass body obtained is difficult to handle without treatment. Therefore, the porous TiO₂-SiO₂ glass body is held at 1,200°C for 4 hours in air in a state of still deposited on the substrate for deposition, and then removed from the substrate for deposition.

### (Step (b))

The porous TiO₂-SiO₂ glass body is held at 1,400°C for 4 hours under reduced pressure of an atmosphere containing nitrogen gas as a main component using a rotary pump and an oil diffusion pump, to thereby obtain a TiO₂-SiO₂ dense body.

### (Step (c))

The TiO₂-SiO₂ dense body obtained is placed in a carbon mold and held therein at 1,680°C for 4 hours in an atmospheric pressure argon gas atmosphere, to thereby obtain a transparent TiO₂-SiO₂ glass body.

### (Step (d))

The transparent TiO₂-SiO₂ glass body obtained is placed in a carbon mold and held therein at 1,700°C for 4 hours in an atmospheric pressure argon gas atmosphere to conduct molding, to thereby obtain a molded TiO₂-SiO₂ glass body.

### (Step (f))

The molded TiO₂-SiO₂ glass body obtained is cut into a plate having about 153.0 mm long x about 153.0 mm wide x about 6.75 mm thick using an inner blade slicer, and then chamfered to obtain a plate material having about 153.0 mm long x about 153.0 mm wide x about 6.7 mm thick. A main surface (surface on which print pattern is to be formed) of the plate material is subjected to grinding with a slurry that is obtained by suspending 18 to 20% by mass of a polishing material (manufactured by Heisei Sankei Co., Ltd., AZ#1000) substantially containing Al₂O₃ in filtered water, using a 20B double-side lapping machine (manufactured by SpeedFam Co., Ltd.), until the thickness becomes about 6.5 mm.

Subsequently, as a first polishing step, the main surface of the plate material is polished about 50 µm by a foamed polyurethane polishing pad and an abrasive material containing cerium oxide as a main component, using a 20B double-side polishing machine.
Further, as a second polishing step, the main surface of the plate material is polished about 15 µm by a suede polishing pad and an abrasive material containing cerium oxide as a main component using a 24B double-side polishing machine.
Further, a third polishing step is conducted with another polishing machine to obtain a TiO₂-SiO₂ glass substrate. The third polishing step uses a suede polishing pad and colloidal silica.

TiO₂ concentration in the TiO₂-SiO₂ glass substrate obtained is measured. The TiO₂ concentration is 6.2% by mass. Imprint simulation test is conducted using the TiO₂-SiO₂ glass substrate obtained. The period of time until disappearance of bubbles is 17 seconds.

A plurality of concave portions having a width of 100 nm and a depth of 30 nm are formed in parallel on the surface of the TiO₂-SiO₂ glass substrate at 200 nm pitch by reactive ion etching by SF₆, to obtain a mold.
Regarding the mold obtained, arithmetic average roughness Ra of a bottom face of the concave portions is measured. The average value is 14 nm.

Continuous print test is conducted. Articles in which defects are not found on the convex portions and a cured product having a fine concave and convex structure formed on a surface thereof is formed on a surface of a respective silicon wafer can be obtained well.

### [Example 2]

### (Step (a))

SiCl₄ as a glass forming raw material is gasified, and then subjected to heat hydrolysis (flame hydrolysis) in oxyhydrogen flame to obtain SiO₂ glass fine particles. The particles are deposited on a substrate for deposition and are grown thereon, to thereby form a porous SiO₂ glass body.
The porous SiO₂ glass body obtained is difficult to handle without treatment. Therefore, the porous SiO₂ glass body is held at 1,200°C for 4 hours in air in a state of still deposited on the substrate for deposition, and removed from the substrate for deposition.

### (Step (b) and Step (c))

Thereafter, the porous SiO₂ glass body is held at 1,450°C for 4 hours under reduced pressure of an atmosphere containing nitrogen gas as a main component using a rotary pump and an oil diffusion pump, to thereby obtain a transparent SiO₂ glass body.

### (Step (d))

The transparent SiO₂ glass body obtained is placed in a carbon mold and held therein at 1,750°C for 4 hours in an atmospheric pressure argon gas atmosphere to conduct molding, to thereby obtain a molded SiO₂ glass body.

### (Step (f))

The molded SiO₂ glass body obtained is subjected to grinding and polishing in the same manners as in Example 1 to obtain an SiO₂ glass substrate.

TiO₂ concentration in the SiO₂ glass substrate obtained is measured. The TiO₂ concentration is 0% by mass. Imprint simulation test is conducted using the SiO₂ glass substrate obtained. The period of time until disappearance of bubbles is 21 seconds.

A plurality of concave portions having a width of 100 nm and a depth of 30 nm are formed in parallel on the surface of the SiO₂ glass substrate at 200 nm pitch by reactive ion etching by SF₆, to obtain a mold.
Regarding the mold obtained, arithmetic average roughness Ra of a bottom face of the concave portions is measured. The average value is 9 nm.

Continuous print test is conducted. Percentage that an article in which defects are not found on the convex portions and a cured product having a fine concave and convex structure formed on a surface thereof is formed on a surface of a respective silicon wafer is obtained is 90% of Example 1.

Although the present invention has been described in detail and by reference to the specific embodiments, it is apparent to one skilled in the art that various modifications or changes can be made without departing the spirit and scope of the present invention.
This application is based on Japanese Patent Application No. 2010-022235 filed on February 3, 2010, the content of which is incorporated herein by reference.

### INDUSTRIAL APPLICABILITY

The method for producing an article having a fine concave and convex structure on a surface thereof according to the present invention is useful as a method that can produce an article (intermediates in a production process of a semiconductor device, optical members, recording media, and the like) having a fine concave and convex structure on a surface thereof in good productivity while suppressing defects generated in the fine concave and convex structure.

### DESCRIPTION OF REFERENCE NUMERALS AND SIGNS

- 10: Mold
- 12: Concave portion (inverted structure)
- 20: Photocurable composition
- 30: Substrate
- 40: Article
- 42: Cured product
- 44: Convex portion (fine concave and convex structure)

## Claims

1. A method for producing an article having a fine concave and convex structure on a surface thereof, wherein
the method comprises the following steps (i) to (iii):
(i) step of sandwiching a photocurable composition between a mold having an inverted structure of the fine concave and convex structure on a surface thereof and a substrate such that the photocurable composition is in contact with the surface having the inverted structure of the mold;
(ii) step of irradiating the photocurable composition with light while keeping the photocurable composition sandwiched between the mold and the substrate to cure the photocurable composition to form a cured product; and
(iii) step of separating the mold from the cured product to obtain an article comprising the substrate having on a surface thereof the cured product having the fine concave and convex structure on a surface thereof; and
wherein the mold comprises TiO₂-containing quartz glass, and
at least the step (i) is conducted in a helium gas atmosphere.

2. The method for producing an article having a fine concave and convex structure on a surface thereof according to claim 1, wherein the mold has an arithmetic average roughness Ra of a bottom face of a concave portion in the inverted structure of from 1 to 30 nm.

3. The method for producing an article having a fine concave and convex structure on a surface thereof according to claim 1 or 2, wherein the mold comprises the TiO₂-containing quartz glass having a TiO₂ concentration of from 2 to 10% by mass.

4. The method for producing an article having a fine concave and convex structure on a surface thereof according to any one of claims 1 to 3, wherein the helium gas atmosphere is an atmosphere having a concentration of helium gas of from 50% by volume or more.
